# EUROPEAN PATENT APPLICATION

(11) **EP 2 890 000 A2**
(43) Date of publication of application: **01.07.2015**
(21) Application number: 15157594.1
(22) Date of filing: 04.03.2015
(51) Int. Cl.: H02P 27/00, H02M 5/00, H04B 5/00

(54) **Frequency converter and drive system**

(71) Applicant: ABB Technology Oy, 00380 Helsinki (FI)
(72) Inventor: Uusi-Äijö, Jarmo, 00380 Helsinki (FI)
(74) Representative: Kolster Oy Ab

(57) **Abstract**

Design and manufacturing of frequency converters for different Ingress Protections (IP) ratings is facilitated. A frequency converter comprises an enclosure and an installation position for a display on the enclosure. The frequency converter comprises energy transfer means capable of wireless inductive power transfer to a display installed to the installation position. The frequency converter may be used in a drive system.

## Description

### FIELD

The invention relates to frequency converters and particularly to frequency converters for drive systems.

### BACKGROUND

The following background description art may include insights, discoveries, understandings or disclosures, or associations together with disclosures not known to the relevant art prior to the present invention but provided by the present disclosure. Some such contributions disclosed herein may be specifically pointed out below, whereas other such contributions encompassed by the present disclosure the invention will be apparent from their context.

Frequency converters are used in drive systems to change frequency and magnitude of electricity supplied to a load. Frequency converters have been used in Alternating Current AC motor drives. In exemplary operation, a frequency converter receives AC current from an electrical power supply and converts the frequency of the received AC current to another frequency after which the AC current is supplied to an AC electric. Also further parameters, for example a voltage level, of the received AC current may be changed. The AC motors are used in various applications including but not limited to fans and pumps. In many applications the use of frequency converters can provide significant energy savings and better control of the motor compared to supplying electrical power having a constant frequency.

Different operating environments have different requirements for enclosures of electrical devices in order to prevent water, humidity, dirt or dust from entering the electrical devices. The requirements posed on the electrical devices are defined by Ingress Protection (IP) ratings developed by the European Committee for Electro Technical Standardization (CENELEC) (NEMA IEC 60529 Degrees of Protection Provided by Enclosures - IP Code). Accordingly, an IP rating specifies the environmental protection and safety protection class provided by an enclosure meeting the requirements of the IP rating.

Frequency converters and drive systems using frequency converters are designed and manufactured to meet requirements defined by the IP ratings. For example, in order to meet a high IP rating, the frequency converter can be equipped with a display cover, whereas for a low IP rating the display cover is not necessarily needed, thus not used in order to meet the required IP/NEMA protection class. Different requirements posed by different IP ratings cause that solutions used in frequency converters having different IP ratings are to a significant degree incompatible with each other.

In one example, IP ratings pose requirements for enclosures and connectors on the enclosures of frequency converters. In the present frequency converters displays are connected to the frequency converters by cables that connect to connectors on the enclosure. Due to the different IP ratings, connections between the displays and the frequency converters can be different, which causes a display compatible with one frequency meeting a specific IP rating to be incompatible with another frequency converter meeting another IP rating. Compatibility of displays is challenging to achieve due to different operating environments, while keeping the connectors protected from humidity and dirt, and also without disproportionally increasing costs.

A malfunctioned connector, for example due to corrosion or physical damage to the connector, can prevent connecting a display to the frequency converter, which can cause a service break to the frequency converter. The service break degrades the operational efficiency of the frequency converter and all the systems that rely on the operation of the frequency converter.

### BRIEF DESCRIPTION

The following presents a simplified summary of features disclosed herein to provide a basic understanding of some exemplary aspects of the invention. This summary is not an extensive overview of the invention. It is not intended to identify key/critical elements of the invention or to delineate the scope of the invention. Its sole purpose is to present some concepts disclosed herein in a simplified form as a prelude to a more detailed description.

According to an aspect, there is provided the subject matter of the independent claims. Embodiments are defined in the dependent claims.

One or more examples of implementations are set forth in more detail in the accompanying drawings and the description below. Other features will be apparent from the description and drawings, and from the claims.

Some embodiments facilitate design and manufacturing of frequency converters and drive systems for different IP ratings.

Some embodiments provide wireless power transfer and/or wireless data transfer to a frequency converter display.

### BRIEF DESCRIPTION OF THE DRAWINGS

In the following the invention will be described in greater detail by means of preferred embodiments with reference to the attached drawings, in which
Figure 1 a illustrates an example of a frequency converter according to an embodiment;
Figure 1b illustrates a cross-sectional view of an enclosure for a frequency converter according to an embodiment;
Figures 2a and 2b illustrate wireless connections for transferring power and data between a display and a frequency converter according to embodiments.

### DETAILED DESCRIPTION OF THE INVENTION

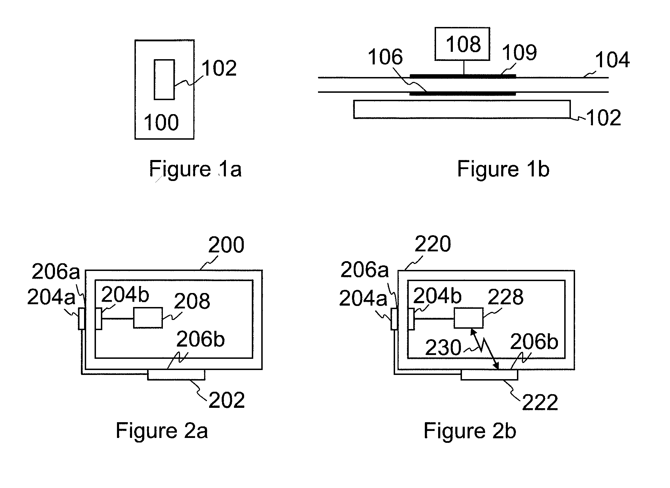

Figure 1 a illustrates an example of a frequency converter according to an embodiment and Figure 1b that illustrates a cross-sectional view of an enclosure for a frequency converter according to an embodiment. A frequency converter according to an embodiment is now described with reference to both Figures 1 a and 1b. The frequency converter 100 comprises an enclosure 104 and an installation position 106 for a display 102 on the enclosure. The frequency converter comprises energy transfer means 108 capable of wireless inductive power transfer to the display installed to the installation position. Electrical power is transferred wirelessly though the enclosure between the energy transfer means located inside the enclosure and the display located outside the enclosure.

The inductive power transfer may be based on electromagnetic induction between the energy transfer means and the display. The electromagnetic induction causes an electric current in the display such that the display is powered by the induced current from the energy transfer means. Since the display is powered wirelessly from the frequency converter, the enclosure may be manufactured and designed without openings for power cables of the display. Since there are no openings for the power cables of the display, the enclosure meets many different IP ratings without needing to redesign the enclosure. In this way also the same enclosure may be manufactured and used in frequency converters to meet different IP ratings.

The energy transfer means capable of inductive power transfer to a display installed to the installation position may follow a principle of an inductively coupled power transfer including a transmitter transfer head, e.g. transmitter coil L1, in the energy transfer means and a receiver transfer head, e.g. a receiver coil L2, in the display. Both transfer heads form a system of magnetically coupled inductors. An alternating current in the transmitter transfer head generates a magnetic field which induces a voltage in the receiver transfer head. This voltage can be used to feed electrical power to the display.

In an embodiment, a display for the frequency converter may include a battery that may be charged at the installation position by the inductive power transfer. It should be appreciated that instead of the batter, a super capacitor or some other applicable power storage may be used. The energy transfer means may be implemented for transferring a suitable charging voltage to the display. The battery may be connected to a transfer head capable of receiving electricity by inductive power transfer.

In an embodiment, a display for the frequency converter is a touch screen capable of displaying a user interface of the frequency converter to a user and obtaining selections of the user on the touch screen. The touch screen may be provided by a tablet computer or a smart phone, for example. On the other hand the display may be a display element especially designed for the motor drive applications. The user interface may be transferred via a data transfer connection from the frequency converter. The data connection may be provided by an inductive connection for the inductive power transfer or by a wireless radio frequency communications.

The touch screen may provide that buttons on the user interface may be very few or even omitted, whereby the user interface may designed and manufactured even without any buttons to facilitate conformance with requirements of various IP ratings. On the touch screen, selections of the user may be obtained by gestures that may include a single touch gesture of the user and/or a multi-touch gesture of the user. The multi-touch gesture may refer to a gesture, where the user touches substantially simultaneously the display area of the display at two or more points of contact. The points of contact may move. Accordingly, the multi-touch gesture allows flexibility to the design of the user interface display on the display and in interpretation of the user's sections.

The energy transfer means may generate electromagnetic waves towards the display. The electromagnetic waves penetrate the enclosure such that electrical power may be transferred by induction from the energy transfer means inside the enclosure to the display located outside of the enclosure. The energy transfer means may comprise supply voltage connection and a transfer head for inductively coupled power transfer by electromagnetic waves. The electromagnetic waves are output towards the display from the transfer head for wireless power transfer to the display. The supply voltage may be provided for example from the frequency converter. The transfer head may be connected to receive electricity from the supply voltage connection for generating electromagnetic waves for wireless power transfer to the display. A receiver transfer head may be used to receive electromagnetic waves transmitted from the transfer head. The receiver transfer head may be matched to the transfer head that is transmitting electromagnetic waves for efficient power transfer from the transmitter to the receiver transfer head. Examples of the transfer heads comprise coils.

In an embodiment, a frequency converter may be capable of data transfer over an inductive power transfer connection to the display. The frequency converter may comprise an energy transfer means capable of wireless inductive power transfer and data transfer. A transfer head of the energy transfer means may serve as an antenna, for example a coil antenna, capable of transmitting and/or receiving data and power. The display may include a receiver transfer head capable of receiving an inductive power transfer and capable of inductive data communications with the transfer head of the energy transfer means.

The energy transfer means may be supplied by alternating current for inductive power transfer to the display via the transfer head, e.g. a coil. The data transfer may be provided by modulating the alternating current fed to the transfer head. Various modulation methods ay be used, including for example one of Pulse Amplitude Modulation, Pulse Position Modulation, Pulse Density Modulation and Pulse Code Modulation. The data signal may comprise data symbols according to a modulation scheme. The alternating current may be fed to the transfer head and received at the display by the receiver transfer head. The received alternating current in the receiver transfer head may be demodulated to obtain the data signal. Accordingly, in this way the transfer heads in the inductive power transfer may serve for both power transfer and data transfer. For a two-way data transmission both the modulation and demodulation may be performed in both the display and the frequency converter as described above. The data transfer functionalities, for example modulation and de-modulation, may be provided in the frequency converter, energy transfer means and/or the display by dedicated units. Examples of the units comprise a modulator and a demodulator. On the other hand the data transfer functionalities may be combined into other units of the frequency converter, energy transfer means and/or the display.

The enclosure may be of a material having a good permeability of electromagnetic waves. The electromagnetic waves may be communications signals and/or electromagnetic waves for wireless power transfer. In one example, the enclosure may be of plastics. Also other composite materials may be used. The installation position may include one or more portions of the surface of the enclosure. The portion may be defined by the material of the enclosure and/or by an area of the surface of the enclosure, where a display, energy transfer means and/or a transfer head are arranged.

The installation position may be matched to the display such that the display may be in contact with the enclosure at the installation position or display be positioned at a very small distance from the installation position. Fastening means, for example adhesives clamps, support structures and/or protrusions on the enclosure may be used to install the display to the installation position. Preferably the forms of the display and the installation position mare matched such that the forms e.g. curvatures, straight or curved, of the display and the installation position may correspond to each other at least substantially. The matching forms of the display and the installation position may provide a close fit between the display and the enclosure such that efficient transfer of electrical energy and/or data through the enclosure may be provided.

Preferably an installation position provides mobility to a display installed to the installation position. In this way a user, for example an operator of the frequency converter, may install the display to the installation position for operating the frequency converter and remove the display to be used for other tasks away from the frequency converter. In one example of other tasks, the display may be installed to another frequency converter for operating it.

On the other hand an installation position may provide that a display installed to the installation position is fitted to the installation so that display element is not manually detachable. Accordingly, removing the display would require tools.

In an embodiment, an energy transfer means 108 of the frequency converter may be arranged to a location 109 on an inside surface of the enclosure 104 and the installation position 106 for a display is outside of the enclosure on an opposite side of the enclosure to the location of the energy transfer means. The energy transfer means may be attached to the location on the inside surface or a conductor may connect the energy transfer means to the location on the inside surface. The conductor may be an electrical conductor, for example a cable. When the energy transfer means are attached to the location on the inside surface the energy transfer means may generate electromagnetic waves for transfer of power and/ or data through the enclosure. The electromagnetic waves may be output from a transfer head of the energy transfer means to the display. When the energy transfer means are connected to the location on the inside surface by the conductor, at least the transfer head of the energy transfer means may be attached to the inside surface for transferring electrical energy and/or data between the energy transfer means and the inside surface.

In an embodiment, a frequency converter may be capable of data transfer by a wireless radio frequency communications with the display. The data transfer may be provided by a radio communications interface. The radio communications interface may be provided by a module or circuitry that may be connected to the frequency converter, for example to energy transfer means of the frequency converter.

The wireless radio frequency communications may comprise radio frequency communications on a frequency band that is reserved internationally for the use of radio frequency energy for industrial, scientific and medical (ISM) purposes. The ISM frequency bands comprise for example 100 MHZ wide frequency band centered at 2.450 GHz.

In one example, the radio frequency communications may be provided by Near Field Communications (NFC). The NFC enables devices to establish radio communications with each other by touching them together or bringing them into proximity, typically a distance of 10 cm or less. The NFC uses electromagnetic induction between two loop antennas located within each other's near field, effectively forming an air-core transformer. Further examples of the radio frequency communications comprise Bluetooth communications and Wi-Fi communications. Circuitries and modules for implementing the Wi-Fi, Bluetooth and NFC communications are commercially available.

In an embodiment, the frequency converter may be a part of a drive system, for example a variable speed drive system or a variable frequency drive system. The drive system may include an electric motor, for example an AC motor and the frequency converter that is connected to the electric motor for supplying electrical power to the motor. The drive system may further include a Programmable Logic Controller (PLC) consisting of one or more a Central Processing Units (CPUs), Input/Output (I/O) modules, communication modules, and/or communication interface modules. A CPU may comprise one or more processors and memory that are electrically connected such that data for example software code stored to the memory may be executed in the processor(s).

The frequency converter has an input, where it receives electrical power from an electrical power supply. The frequency converter has an output that supplies electrical power obtained by converting the frequency and/or further characteristics of the electrical power received in its input. The electrical power supplied by the frequency converter can have a different frequency than the input electrical power, since the frequency of the input electrical power is converted by the frequency converter to match properties of the electrical motor and/or properties of a pump or fan driven by the electric motor.

Figures 2a and 2b illustrate wireless connections for transferring power and data between a display 202, 204a and a frequency converter 200, 220 according to embodiments. The data may comprise data for displaying a user interface of the frequency converter on the display. The frequency converter may be the frequency converter described with Figures 1 a or 1 b with the difference that in Figures 2a and 2b, the frequency converter has at least two installation positions 206a, 206b for the display on the enclosure. One of the installation positions 206a is for inductive power (and data) transfer to the display and another position 206b is for a portion 202 of the display for displaying a user interface of the frequency converter. The portion 202 of the display for displaying the user interface includes the part of the display capable of displaying the user interface and may be referred to as a screen unit. An example of the screen unit is a Liquid Crystal Display (LCD). The displayed information may comprise for example one or more of a menu, monitored signal and/or parameter of the frequency converter. A transfer head 204a may be connected to the screen unit by an electrical conductor, for example a cable. The transfer head may be positioned to the installation position 206a for inductive power transfer.

In one example, the display may be a tablet computer that is connected by a Universal Serial Bus (USB) cable to the transfer head. In an embodiment, power and data may be communicated by the inductive connection provided by the transfer head. In an embodiment power may be communicated by the inductive connection provided by the transfer head and data may be communicated by wireless radio frequency communications, for example NFC, Bluetooth or Wi-Fi, between the tablet and the frequency converter.

It should be appreciated that an installation position for displaying a user interface should be such that it is at a height that is suitable for viewing the user interface on the screen unit installed to the installation position. The installation position should preferably be inclined such that the user interface may be viewed from above by people of various heights. The inclination may be provided by an inclination of the frequency converter enclosure. Preferably the installation position for displaying a user interface is at a height between 1.2m and 1.7m on the frequency converter enclosure, as measured from the ground or floor. The inclined installation position may be at a height between 1.3 and 1.6m.

The frequency converter may comprise energy transfer means 204b, 208, 228 arranged to a location on an inside surface of the enclosure. The installation position 206a for inductive power transfer to the display is outside of the enclosure on an opposite side of the enclosure to the location of the energy transfer means 204b on the inside surface. A transfer head 204b of the energy transfer means may be arranged to the location on the inside surface and connected to the energy transfer means by a conductor. The energy transfer means are described in more detail above.

In the embodiment illustrated in Figure 2a, a single wireless connection is provided for power and/or data transfer to the display at the installation position 206a for inductive power and/or data transfer. The single wireless connection may be an inductive connection, where both data and power may be transferred between the frequency converter 200 and the display. The single wireless connection to the display provides that the enclosure may be designed to allow wireless communications only at the single installation position on the enclosure.

In the embodiment illustrated in Figure 2b, the frequency converter 220 is capable of wireless radio frequency communications 230 and capable of wireless inductive power transfer over an inductive connection to the display. The energy transfer means 228 may be a wireless communications unit capable of wireless radio frequency communications with the display and capable of inductive power transfer to the display. Accordingly data may be transferred over a radio frequency connection to the display and power may transfer may be transferred over an inductive connection. In this way the display may be connected to the frequency converter only for power transfer or data transfer. Even two or more displays may be connected to the frequency converter at a time. When two displays are connected to the frequency converter, one of the displays maybe connected for inductive power transfer. In this way the frequency converter may be used for charging a battery inside the display connected for inductive power transfer. On the other hand one of the connected displays may be connected to the frequency converter only for data transfer over the radio frequency connection. The display connected to the frequency converter for data transfer may be removed from the installation position by a user to be used in other tasks, for example for data communications with another frequency converter.

The techniques described herein may be implemented by various means so that an apparatus implementing one or more functions of a display or a frequency converter described with an embodiment comprises not only prior art means, but also means for implementing the one or more functions of a corresponding apparatus described with an embodiment and it may comprise separate means for each separate function, or means may be configured to perform two or more functions. For example, these techniques may be implemented in hardware (one or more apparatuses), firmware (one or more apparatuses), software (one or more modules), or combinations thereof. A hardware implementation may be through one or more circuits, for example Application Specific Circuits (ASICs). For a firmware or software, implementation can be through modules (e.g., procedures, functions, and so on) that perform the functions described herein. The software codes may be stored in any suitable, processor/computer-readable data storage medium(s) or memory unit(s) or article(s) of manufacture and executed by one or more processors/computers. The data storage medium or the memory unit may be implemented within the processor/computer or external to the processor/computer, in which case it can be communicatively coupled to the processor/computer via various means as is known in the art.

It will be obvious to a person skilled in the art that, as the technology advances, the inventive concept can be implemented in various ways. The invention and its embodiments are not limited to the examples described above but may vary within the scope of the claims.

## Claims

1. A frequency converter comprising an enclosure and an installation position for a display on the enclosure, wherein the frequency converter comprises energy transfer means capable of wireless inductive power transfer to a display installed to the installation position.

2. A frequency converter according to claim 1, wherein the energy transfer means are arranged to a location on an inside surface of the enclosure and at least a part of the installation position is outside of the enclosure on an opposite side of the enclosure to the location of the energy transfer means on the inside surface.

3. A frequency converter according to claim 1 or 2, wherein the frequency converter is capable of data transfer over an inductive connection to the display.

4. A frequency converter according to claim 1 or 2, wherein the frequency converter is capable of wireless radio frequency communications with the display.

5. A frequency converter according to 4, wherein the enclosure has at least two installation positions for the display, wherein the at least two installation positions comprise a first installation position for inductive power transfer and a second installation position for displaying a user interface of the frequency converter.

6. A frequency converter according to claim 5, wherein the display is connected to the first installation position and another display is connected to the second installation position.

7. A frequency converter according to any one of the preceding claims, wherein the display is a touch screen.

8. A frequency converter according to any one of the preceding claims, wherein the display is charged at the installation position by the inductive power transfer.

9. A drive system comprising a frequency converter according to any one of claims 1 to 8.
